# EUROPEAN PATENT APPLICATION

(11) **EP 2 112 872 A2**
(43) Date of publication of application: **28.10.2009**
(21) Application number: 09157969.8
(22) Date of filing: 15.04.2009
(51) Int. Cl.: H05K 5/00

(54) **Over-molded Electronic Module**

(30) Priority: 23.04.2008 US 148832
(71) Applicant: Delphi Technologies, Inc., Troy, Michigan 48007 (US)
(72) Inventor: Lu, Bo, Westfield, IN 46074 (US)
(74) Representative: Denton, Michael John

(57) **Abstract**

An over-molded electronic module (2) includes a frame (10), an electronic assembly (20), and a polymeric body (32). The frame (10) includes a sidewall (14) that defines an opening (12) to provide a position for the electronic assembly (20), and includes an upper face (16) and a lower face (18) opposite the upper face (16) to act as sealing surfaces during over-molding. The polymeric body (32) is formed of a polymeric composition encapsulating both sides of the electronic assembly (20) and a portion of the frame (10).

## Description

### TECHNICAL FIELD

The invention relates to an over-molded electronic module that includes an electronic assembly received within a frame and a polymeric body overlying the electronic assembly. More particularly, this invention relates to such over-molded electronic modules wherein the polymeric body includes an upper portion overlying the upper surface of the electronic assembly within an upper region of the frame and a lower portion overlying the lower surface of the electronic assembly within a lower region of the frame.

### BACKGROUND OF INVENTION

Electronic modules containing electronic assemblies experience severe environmental conditions such as corrosion by contaminants, vibration, wide temperature fluctuations, and combinations thereof, especially when used in automotive applications. For this reason, automotive electronic assemblies are commonly sealed within housings made from polymer or metal. Sealing the housing protects the enclosed electronic assembly from contaminants such as water, salt, gasoline, and oil. The housings also provide support structures that reduce flexing of the electronic assembly, thereby protecting the electronic assembly from vibration and impact damage. The assembly and fabrication of separate housing pieces, seals, and fasteners undesirably increases the cost of the module. The housing also results in a larger module, leading to cramped engine compartments and under-dash areas.

It is known to over-mold an electronic assembly within a polymeric body to provide a lower cost, smaller electronic module. Polymeric compositions that adequately protect the assembly from automotive contaminants are readily available. However, while rigid polymeric compositions provide good protection from vibration and impact by reducing flexing of the electronic assembly, the thermal expansion characteristics of rigid polymeric compositions can damage the electronic assembly by stressing the solder joints that attach electronic components to the circuit board. Alternatively, softer polymeric compositions reduce solder joint stress, but tend to be more flexible and so reduce the level of vibration and impact protection.

It is also known that over-molding an electronic assembly requires that the electronic assembly be positioned and supported in the mold during over-molding. The over-molding process injects polymeric composition at pressures that may deform and damage the circuit board if the circuit board is not properly supported. A common practice is to support the assembly against the mold surface. However, this only allows one side of the assembly to be over-molded. Another method uses retractable support pins as part of the mold tooling to support the electronic assembly during over-molding. However, this adds complexity and cost to the over-molding process.

What is needed is an improved electronic module that is over-molded with a polymeric composition to protect both upper and lower surfaces and components while reducing stress to solder joints due to thermal expansion, and which is also reinforced to protect against vibration and impact damage.

### SUMMARY OF THE INVENTION

In accordance with this invention, an over-molded electronic module includes a frame defining an opening. The frame includes a sidewall, an upper face, and a lower face opposite the upper face. An electronic assembly is received in the frame opening. The assembly includes an upper surface spaced apart from the upper face by an upper region, and a lower surface spaced apart from the lower face by a lower region. The electronic module also includes a polymeric body formed of a polymeric composition. The polymeric body includes an upper portion and a lower portion. The upper portion overlays the upper surface within the upper region. The lower portion overlays the lower surface within the lower region.

A method to make the over-molded electronic module includes the step of arranging the electronic assembly within the opening defined by a frame. This arrangement divides the opening into an upper region and a lower region. The method further includes positioning the arrangement within a mold such that the mold seals against the frame. A polymeric composition is injected into the mold to form the polymeric body and encapsulate the electronic assembly within the frame. The electronic module is then removed from the mold.

### BRIEF DESCRIPTION OF DRAWINGS

This invention will be further described with reference to the accompanying drawings in which:

Fig. 1 is a perspective view of a frame for use in a preferred embodiment of the invention;

Fig. 2 is a perspective view, similar to Fig. 1 showing an arrangement of the frame and an electronic assembly prior to over-molding;

Fig. 3 is a perspective view, similar to Fig. 2, of an over-molded electronic module in accordance with this invention;

Fig. 4 is a perspective view, similar to Fig. 2, showing the arrangement of Fig. 2 within a mold during over-molding to form the electronic module in Fig. 3;

Fig. 5 is a side cross sectional view showing the arrangement in Fig. 4, taken along line 5-5 with direction of arrows;

Fig. 6 is a perspective view, similar to Fig. 3, of an over-molded electronic module in accordance with this invention; and

Fig. 7 is a side cross sectional view of the electronic module in Fig. 6, taken along line 7-7 in the direction of the arrows.

### DETAILED DESCRIPTIONS OF INVENTION

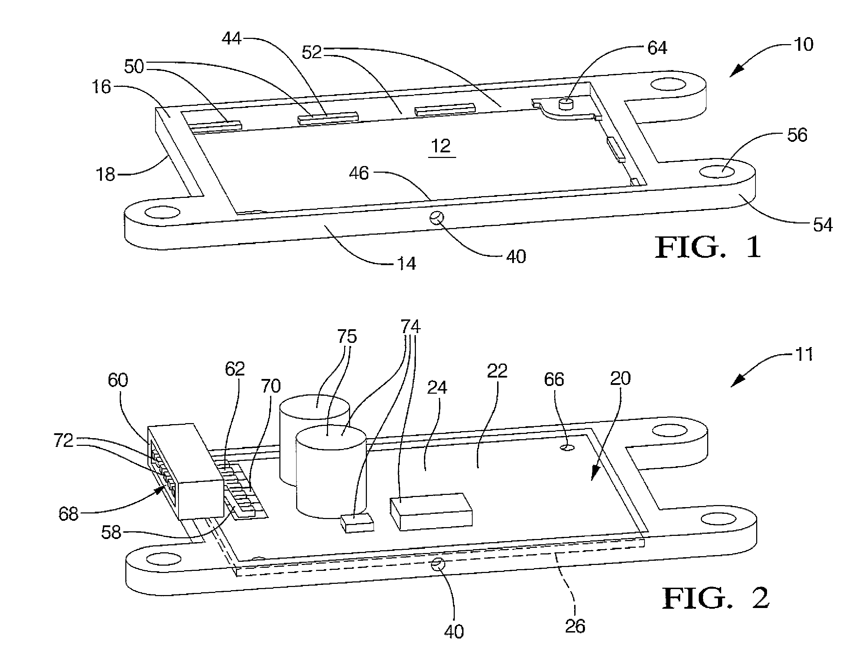

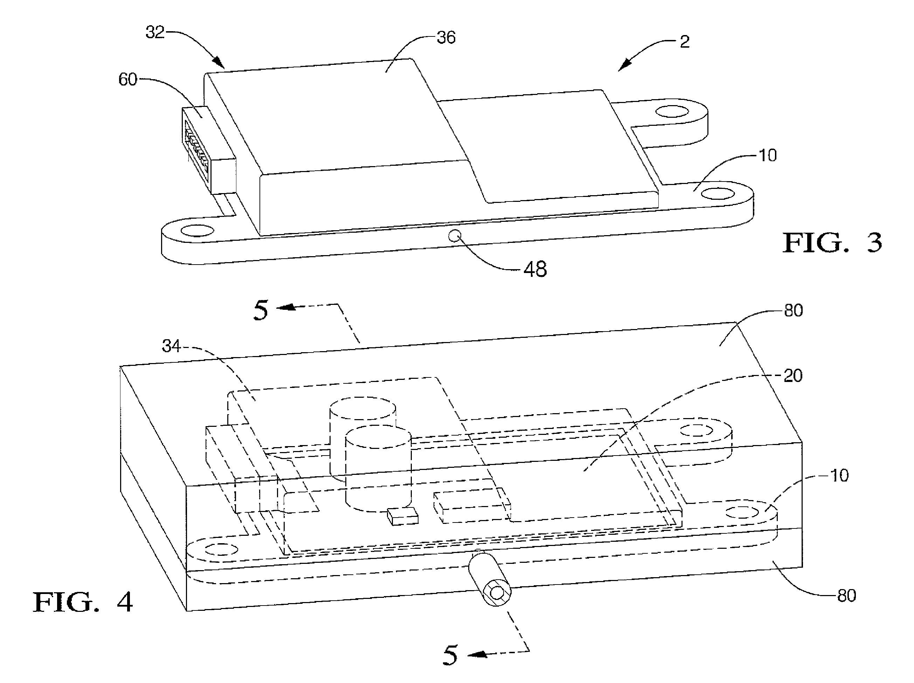

In accordance with a preferred embodiment of the invention, over-molded electronic module 2, in Figs. 3, 6 and 7, includes, as main elements, a frame 10, shown in Fig.1, an electronic assembly 20, shown in Fig. 2, and a polymeric body 32. Polymeric body 32 is formed by over-molding an arrangement 11 in Fig. 2 of frame 10 and electronic assembly 20 with polymeric composition. Polymeric body 32 and frame 10 cooperate to protect electronic assembly 20 from damage. In this example, electronic module 2 is an electronic control unit for a passenger occupant detection system in an automotive vehicle.

Referring to Fig. 1, frame 10 includes an upper face 16 and a lower face 18 opposite upper face 16, and defines an opening 12 surrounded by a sidewall 14. The outer perimeter of upper face 16 and lower face 18 provide surfaces for sealingly engaging a mold during over-molding operations. In this embodiment, frame 10 is formed of metal having stiffness effective to provide enhanced reinforcement to the module. The material forming frame 10 is cast aluminum, where upper face 16 and lower face 18 are machined to provide a smooth surface for sealing during over-molding. Alternately, the frame is suitably formed of ceramic or a polymeric material. It is advantageous for frame 10 to have a suitable surface for bonding to polymeric body 32.

Sidewall 14 includes a ledge 44 formed of ledge segments 50 spaced apart by gaps 52 and arranged circumferentially about opening 12 for supporting electronic assembly 20. Positioning and supporting circuit board 22 on ledge segments 50 during over-molding simplifies the molding operation by eliminating mold tooling complications, thereby reducing the cost of electronic module 2. Frame 10 includes a locator pin 64 for properly orienting assembly 20 within frame 10. Frame 10 also includes a fill-hole 40 through sidewall 14 providing a passageway for injecting polymeric composition into the opening 12. Fill-hole 40 communicates with a gap 46 between ledge segments 50 for diverting the polymeric material upwardly and downwardly within the opening. In this embodiment, frame 10 includes mounting bosses 54. Each mounting boss 54 has a bore 56 adapted to receive a fastener for securing electronic module 2 to a support structure (not shown). Alternatively, frame 10 may include clips, prongs, pins or other features suitable to the secure electronic module 2 to a support structure.

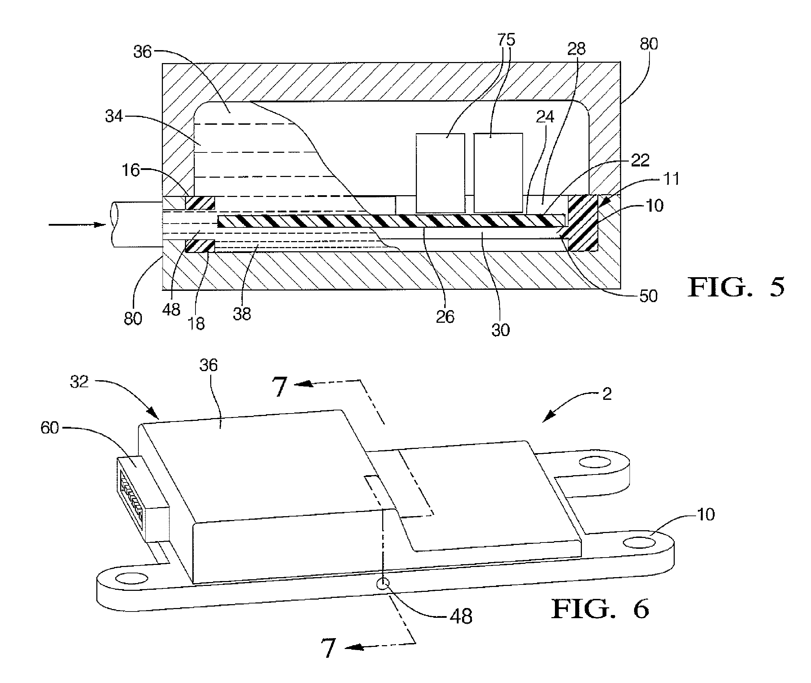

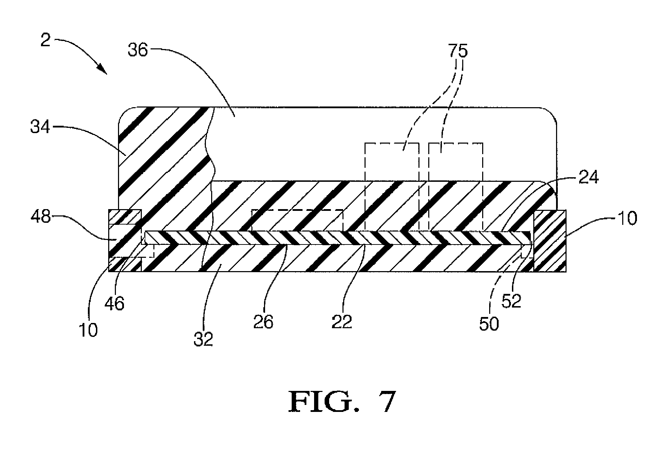

Assembly 20 comprises a circuit board 22 having an upper surface 24 and a lower surface 26 such that upper surface 22 is spaced apart from upper face 16 by an upper region 28 and lower surface 26 is spaced apart from lower face 18 by a lower region 30, as shown more particularly in Fig 5 and Fig. 7. Upper surface 24 is populated by electronic components 74 including capacitors 75, resistors, and integrated circuits, and circuit traces (not shown) for electrically connecting the components. In this embodiment, some of the electronic components, mainly capacitors 75, protrude from upper surface 24 through the plane established by upper face 16.

Referring more particularly to Fig. 2, electronic assembly 20 includes a plurality of connector pins 58. Connector pins 58 include contact ends 70 for making electrical contact with circuit board 22, and exposed ends 72 for making electrical contact to an electrical connector (not shown). Ends 70 are soldered to circuit board 22. Alternatives to soldering include crimping, wire-wrap, and spring type connectors. Connector pin 58 is insert-molded into header 60 that surrounds ends 72, thereby forming a connector assembly. The connector assembly simplifies manufacturing of electronic assembly 20 by fixing the relative positions of individual pins. Header 60 provides a shroud to protect connector ends 72 from being bent or otherwise damaged during handling or shipping of electronic assembly 20 and electronic module 2. Header 60 simplifies the mold sealing features required to seal around connector pin 58 for over-molding. Header 60 in contact with upper face 16 simplifies the sealing features required of a mold necessary to seal the region between header 60 and upper face 16 for over-molding.

Electronic assembly 20 has a hole 66 that is adapted to receive post 64 for positioning of electronic assembly 20 with respect to sidewall 14, thereby reducing motion of electronics assembly with respect to frame 10 during over-molding. In this example, it is desired to provide an electrical connection between the electrical circuit on circuit board 22 and the metal frame. Accordingly, hole 66 is plated with metal to form a plated via and makes electrical contact with post 64. Electrical connection between the circuit and the frame may be suitable for providing a ground plane to protect electronic assembly 20 from interference by electromagnetic energy. Electrical connection can also provide a power ground or voltage sensing connection to the support structure to which the electronic module is attached.

Referring now to Figs. 3, 6 and 7, polymeric body 32 includes an upper portion 36 that overlies upper surface 24 in upper region 28 and a lower portion 38 that overlies lower surface 26 in lower region 30, thereby encapsulating circuit board 22 therein. Body 32 is formed by a polymeric composition 34 injected through fill-hole 40, thereby forming a residual tail portion 48 within the fill-hole. The relative positions of fill-hole 40 and electronic assembly 20 are arranged so polymeric composition injected through fill-hole 40 flows upwardly and downwardly within opening 12, thereby forming both upper portion 36 and lower portion 38 of polymeric body 32 during over-molding. Ledge segments 50 are spaced apart by gaps 52 to facilitate flow of polymeric composition during over-molding. Gaps 52 provide passageways for polymeric composition to flow between upper region 28 and lower region 30 thereby coupling upper portion 36 and lower portion 38 together to form a stronger polymeric body 32 and secure frame 10 within polymeric body 32. Flow of polymeric composition 34 into both regions and through gaps 52 also allows over-molding to be completed by a single injection, thereby minimizing cost. Also, since circuit board 22 does not need to provide openings for the flow of polymeric composition 34 between upper region 28 and lower region 30, circuit board 22 can be smaller and therefore less expensive. Over-molding also fills fill-hole 40 with polymeric composition 34 forming a tail portion 48 disposed within fill-hole 40, where tail portion 48 is part of polymeric body 32. Another advantage of fill-hole 40 is over-molding tooling costs are minimized by providing a simple and consistent injection tool interface for a variety of electronic module sizes and shapes.

In this embodiment, polymeric body 32 is formed of a polymeric composition 34. The polymeric body protects electronic components 74 from contact with foreign objects, seals both sides of electronic assembly 20 to reduce corrosion, extends through gaps 52 to secure electronics assembly 20 within polymeric body 32, extends over the inner perimeter of over upper face 16 and lower face 18 to secure frame 10 within module, and partially encapsulates embedded section 62. A preferred material is thermoplastic hot melt based on polyamide. Alternately, polymeric composition 34 may be a heat cure epoxy. It is advantageous to select polymeric composition 34 suitable for hermetic bonding to the frame 10 to provide enhanced sealing of the module. A hermetic bond also increases the mechanical strength of the over-molded electronic module 2 by fixedly coupling frame 10 to polymeric body 32. It is also advantageous that frame 10 is formed of a material stiffer and stronger than polymeric composition 34 so electronic assembly 20 is better protected when a softer material that does not cause thermal damage to solder joints is used for polymeric composition 34.

Body 32 includes an upper portion 36 that extends above frame 10 and is molded about header 60. In an alternate embodiment that does not include a header 60, pins 58 are embedded within the body with connector ends 72 being exposed to allow access for electrical connections to the assembly. In this alternative embodiment, body 32 may include a protective shroud portion surrounding the connector ends.

The method for manufacturing electronic module 2 is now described. Frame 10 is suitably formed by a metal casting operation. Alternately, the frame 10 may be stamped, machined, or molded. Electronic assembly 20 is made by conventional methods of soldering electronic components 74 and connector pins 58 to a circuit board 22 where the solder joints need to be protected from damage during use. Frame 10 and assembly 20 are arranged, thereby forming an arrangement 11, shown in Fig. 2, prior to over-molding. The arrangement 11 is placed into mold 80, shown in Fig. 4, and polymeric composition 34 is injected into mold 80, shown in Fig. 5, to form over-molded electronic module 2.

Referring now to Fig. 5, the arrangement is positioned within a mold 80 such that mold 80 seals against the outer perimeter of upper face 16 and lower face 18 of frame 10 and circuit board 22 positioned upon ledge segments 50. The separation between upper face 16 and upper surface 24 defines upper region 28 and the separation between lower face 18 and lower surface 26 defines lower region 30. Polymeric composition 34 is injected into the cavity through fill-hole 40 formed by mold 80 in the direction shown by the arrow, filling upper region 28 thereby forming an upper portion 36 of polymeric body 32, and filling lower region 30 thereby forming a lower portion 38 of polymeric body 32. Forming polymeric body 32 over-molds electronic assembly 20 and frame 10, thereby encapsulating and protecting electronic assembly 20, and forming over-molded electronic module 2 during a single over-molding operation, thereby reducing the cost of over-molding.

In this embodiment, polymeric composition 34 is injected through fill-hole 40. The position of fill-hole 40 with respect to circuit board 22 is advantageously arranged so polymeric composition 34 flows over, under, and around circuit board 22, and through gaps 52.

After mold 80 is completely filled and the necessary steps are taken so the specific polymeric composition 34 selected will maintain the shape defined by the mold (e.g. - cooling or waiting a prescribed period of time), electronic module 2 is removed from mold 80. When the finished electronic module 2 is ejected from mold 80, tail portion 48 is separated from any polymeric composition 34 remaining in the injection tooling, thereby minimizing post over-molding steps necessary to finish fabricating over-molded electronic module 2.

Thus, this invention provides an over-molded electronic module that includes an electronic assembly encapsulated within a polymeric body. Encapsulation provides simple, low cost protection to electronic components and solder-joints from corrosive chemicals, dirt, and moisture. It also provides protection to the electronic assembly from mechanical damage resulting from unexpected contact with objects. The mechanical strength of the module is reinforced by a frame. The combination of a stiff frame and an over-molded polymeric body protects the electronic assembly from other forms of damage damage, including damage due to vibration from an automotive engine or due to mechanical shock and impact from a vehicle collision. The frames simplifies the over-molding process by supporting and positioning the electronic assembly during over-molding, providing an upper face and lower face for the mold to seal against, and providing a fill-hole through which over-molding material is injected, all of which reduce the cost of over-molding. The frame also provides other valuable features such as a means for making an electrical connection to the frame and mounting bosses for attaching the electronic module to a support structure.

In one aspect, this invention allows the advantages of a polymeric material to be combined with the advantages of a metal frame. The metal frame provides strength to withstand compressive forces, including forces experienced during the over-molding operation. It is advantageous that the frame material be stiffer and stronger than the over-molding polymeric composition and so provides structural reinforcement for the electronic module. Reinforcement increases the level of mechanical protection provided to electronic assembly, particularly when polymeric body is formed using softer material selected to avoid thermal stressing of electronic assembly.

While this invention has been described in terms of the preferred embodiments thereof, it is not intended to be so limited, but rather only to the extent set forth in the claims that follow.

## Claims

1. An over-molded electronic module comprising:
a frame defining an opening and comprising a sidewall, an upper face, and a lower face opposite the upper face;
an electronic assembly received in the opening, the electronic assembly comprising a upper surface and a lower surface, the upper surface being spaced apart from the upper face by an upper region, the lower surface being spaced apart from the lower face by a lower region; and
a polymeric body formed of a polymeric composition, said polymeric body comprising an upper portion overlying the upper surface within the upper region and a lower portion overlying the lower surface within the lower region.

2. The over-molded electronic module in accordance with claim 1, wherein the sidewall further comprises a fill-hole extending through the sidewall for injecting polymeric composition into the opening, and wherein the polymeric body extends within the fill-hole.

3. The over-molded electronic module in accordance with claim 1, wherein the frame comprises a ledge supporting the electronic assembly within the opening.

4. The over-molded electronic module in accordance with claim 3, wherein the ledge defines a gap, and further wherein the sidewall comprises a fill-hole extending through the sidewall intersecting the gap, and wherein the polymeric body fills the fill-hole and extends within the gap to connect the upper portion and the lower portion.

5. The over-molded electronic module in accordance with claim 3, wherein the ledge comprises a plurality of ledge segments disposed circumferentially about the opening and spaced apart by a plurality of gaps, and wherein the polymeric body extends within the gaps to connect the upper portion and the lower portion.

6. The over-molded electronic module in accordance with claim 1, wherein the frame further comprises a mounting boss for mounting the electronic module to a support structure.

7. The over-molded electronic module in accordance with claim 1, wherein the electronic assembly comprises a circuit board, said circuit board comprising the upper surface and the lower surface.

8. The over-molded electronic module in accordance with claim 1, wherein the polymeric composition is sealed to the frame.

9. The over-molded electronic module in accordance with claim 1, wherein the frame is formed of an electrically conductive material and is electrically coupled to the electronic assembly.

10. The over-molded electronic module in accordance with claim 1, wherein the electronic assembly includes a hole, and the frame includes a post received in the hole.

11. The over-molded electronic module in accordance with claim 1, wherein the electronic assembly further includes a connector pin having a contact end and a connector end remote from the contact end, wherein the contact end is electrically attached to the electronic assembly and encapsulated within the polymeric body, and wherein the connector end is exposed to allow for electrical connection to the electronic assembly.

12. The over-molded electronic module in accordance with claim 11, wherein the electronic assembly further includes a header disposed about the connector pin, shrouding the connector end, and disposed against the upper face of the frame, said header being embedded within the polymeric body.

13. A method for making an over-molded electronic module, the method comprising:
arranging an electronic assembly within an opening defined by a frame such that an upper surface of the electronic assembly is spaced apart for an upper face of the frame to define an upper region and a lower surface of the electronic assembly is spaced apart for a lower face of the frame to define a lower region, thereby forming an arrangement;
positioning the arrangement within a mold defining a mold cavity, whereby the mold seals against the upper face and the lower face of the frame;
injecting a polymeric composition into the mold cavity including the upper region and the lower region to form a polymeric body encapsulating the electronic assembly within the frame, thereby forming an over-molded electronic module; and
removing the electronic module from the mold.

14. A method to make an over-molded electronic module in accordance with claim 14, further comprising
injecting the polymeric composition through a fill-hole in the sidewall.

15. A method to make an over-molded electronic module in accordance with claim 15, further comprising
supporting the electronic assembly within the frame upon a plurality of ledge segments spaced apart by a plurality of gaps, and flowing the polymeric composition within the gaps between the upper region and the lower region.
